(19) **Europäisches Patentamt**
**European Patent Office**
**Office européen des brevets**

(11) **EP 2 446 370 B1**

(12) **FASCICULE DE BREVET EUROPEEN**

(45) Date de publication et mention
de la délivrance du brevet:
**24.11.2021 Bulletin 2021/47**

(21) Numéro de dépôt: **10745318.5**

(22) Date de dépôt: **24.06.2010**

(51) Int Cl.:
*G06K 9/00* *(2006.01)*     *H01M 8/04992* *(2016.01)*
*H01M 8/04664* *(2016.01)*     *G01R 31/367* *(2019.01)*
*H01M 10/42* *(2006.01)*

(86) Numéro de dépôt international:
**PCT/FR2010/051295**

(87) Numéro de publication internationale:
**WO 2010/149935 (29.12.2010 Gazette 2010/52)**

(54) **DÉTECTION DE DÉFAUT DANS UN DISPOSITIF ÉLECTROCHIMIQUE**

ERKENNUNG VON DEFEKTEN BEI EINER ELEKTROCHEMISCHEN VORRICHTUNG

DETECTION OF DEFECTS IN AN ELECTROCHEMICAL DEVICE

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **25.06.2009 FR 0954357**

(43) Date de publication de la demande:
**02.05.2012 Bulletin 2012/18**

(73) Titulaires:
• **Electricité de France**
**75008 Paris (FR)**
• **Institut Français des Sciences et Technologies des**
**Transports, de l'Aménagement et des Réseaux**
**77420 Champs sur Marne (FR)**
• **Université de Franche-Comté**
**25030 Besançon Cedex (FR)**

(72) Inventeurs:
• **YOUSFI-STEINER, Nadia**
**F-90000 Belfort (FR)**
• **MOCOTEGUY, Philippe**
**F-67630 Niederlauterbach (FR)**
• **GAUTIER, Ludmila**
**F-67480 Roeschwoog (FR)**
• **HISSEL, Daniel**
**F-70250 Ronchamp (FR)**
• **CANDUSSO, Denis**
**F-90000 Belfort (FR)**

(74) Mandataire: **Plasseraud IP**
**66, rue de la Chaussée d'Antin**
**75440 Paris Cedex 09 (FR)**

(56) Documents cités:
EP-A2- 0 762 135     CN-A- 1 556 417
JP-A- 2003 223 916     JP-A- 2003 223 916
JP-A- 2006 210 070     JP-A- 2006 210 070
US-A1- 2006 078 788     US-A1- 2008 145 727

• TRUCHETET F., ET AL.: "Review of industrial applications of wavelet and multiresolution-based signal and image processing" JOURNAL OF ELECTRONIC IMAGING, vol. 17, no. 3, 031102, 1 juillet 2008 (2008-07-01), pages 1-11, XP040447075
• BHAMBARE K S ET AL: "A carbon monoxide sensor in polymer electrolyte fuel cells based on symbolic dynamic filtering", SENSORS AND ACTUATORS B: CHEMICAL, ELSEVIER BV, NL, vol. 134, no. 2, 25 September 2008 (2008-09-25), pages 803-815, XP025429974, ISSN: 0925-4005, DOI: 10.1016/J.SNB.2008.06.057 [retrieved on 2008-07-12]
• He Zheng-You ET AL: "Wavelet Entropy Measure Definition and Its Application for Transmission Line Fault Detection and Identification; (Part I: Definition and Methodology)", 2006 International Conference on Power System Technology, 1 October 2006 (2006-10-01), pages 1-6, XP055653051, DOI: 10.1109/ICPST.2006.321939 ISBN: 978-1-4244-0111-6

**Description**

La présente demande concerne le domaine de la détection de défauts dans des dispositifs électrochimiques.

Il existe à l'heure actuelle de multiples dispositifs dits « électrochimiques », c'est-à-dire utilisant la conversion d'énergie chimique en énergie électrique ou vice versa.

Une première catégorie de ce type de dispositifs concerne des dispositifs convertissant de l'énergie chimique en énergie électrique, afin de fournir celle-ci à des appareils électriques ou de la stocker pour pouvoir la fournir ultérieurement. De tels dispositifs peuvent être par exemple des batteries, des piles à combustible ou des supercapacités.

Une deuxième catégorie de ce type de dispositifs concerne les dispositifs utilisant divers procédés faisant appel à l'électricité pour réaliser des réactions chimiques, ou séparer des produits ou des réactifs entre eux. De tels dispositifs utilisent couramment des procédés dits « électrochimiques » tels que l'électrodéposition, l'électroérosion ou l'électroflotation.

La fiabilité et la durée de vie de ces dispositifs électrochimiques sont limitées par divers phénomènes. En ce qui concerne les dispositifs convertissant l'énergie chimique en énergie électrique, comme par exemple les piles à combustibles, deux phénomènes principaux conduisent à la chute de la performance, voire à la défaillance complète du dispositif.

D'une part, le cyclage charge / décharge ou le fonctionnement en mode transitoire, soit par l'accumulation des arrêts et des démarrages soit par les variations de puissance demandée, réduit la durée de vie de ces dispositifs.

D'autre part, certains incidents tels que les défauts de contrôle de certains paramètres du procédé électrochimique utilisé (interruption d'alimentation en réactifs, mauvaise gestion des produits et sous-produits de la réaction), l'empoisonnement du milieu, la défaillance d'un composant ou d'un module par exemple, peuvent survenir pendant leur fonctionnement.

Ainsi, ces phénomènes délétères nécessitent l'utilisation de méthodes de diagnostic afin de permettre leur détection et leur éventuelle correction.

Dans un dispositif électrochimique classique, les méthodes de diagnostic classiques s'appuient le plus souvent sur la connaissance d'un certain nombre de paramètres, qu'ils soient externes ou internes à ces systèmes, nécessitant une instrumentation spécifique, comme par exemple l'insertion de capteurs internes dans le dispositif électrochimique lui-même.

Une telle instrumentation n'est pas toujours souhaitable, car elle est souvent coûteuse et n'est pas toujours facile à mettre en place, compte tenu de la géométrie du système électrochimique rarement adaptée à l'installation de capteurs, notamment internes au dispositif.

De plus, de tels capteurs internes induisent, du fait de leur insertion, une altération du dispositif pouvant augmenter la probabilité d'apparition de défauts et conduisant à de faux diagnostics. Enfin, dans le cas de l'utilisation d'un système électrochimique pour des applications mobiles, la taille du dispositif doit être réduite au minimum, ainsi que celle de l'instrumentation de diagnostic, ce qui ne permet pas d'utiliser les méthodes classiques.

Dans le cas particulier, et non exclusif, des piles à combustibles à membranes échangeuses de protons (PEMFC en anglais pour Proton Exchange Membrane Fuel Cell), des études ont été menées afin de comprendre les mécanismes de dégradation et d'améliorer leur fiabilité et leur durée de vie. Certains modèles physiques ont même été développés. Ils ont cependant besoin d'un certain nombre de paramètres difficilement mesurables, voire non mesurables, pour pouvoir être utilisés. De plus, leur complexité conduit généralement à des besoins importants en temps de calcul qui rendent difficile leur implantation dans une optique de diagnostic en temps réel.

L'article suivant décrit une méthode alternative par filtrage dynamique symbolique (SDF) : Bhambare K S et al. : « A carbon monoxide sensor in polymer electrolyte fuel cells based on symbolic dynamic filtering », SENSORS AND ACTUATORS B: CHEMICAL, ELSEVIER BV, NL, vol. 134, no. 2, 25 septembre 2008 (2008-09-25), pages 803-815.

La présente invention vise à répondre aux inconvénients cités ci-avant.

Un objet de la présente invention est donc de proposer un procédé permettant de détecter de manière non intrusive un défaut dans un dispositif électrochimique.

Par ailleurs, l'invention a aussi pour objet de proposer un procédé de détection de défaut utilisant une instrumentation minimale.

Un autre objet de la présente invention est de proposer un procédé générique de détection de défauts dans un dispositif électrochimique pouvant être utilisé pour différents systèmes, indépendamment de leurs types, géométries, tailles ou applications.

Enfin, un autre objet de la présente invention est de proposer un procédé de détection de défaut utilisable en temps réel.

La présente invention propose à cet effet un procédé de détection d'un défaut d'un dispositif électrochimique tel que défini dans la revendication 1.

Préférentiellement, la variable d'échelle de valeur a vérifie $a=a_0^j$, où j est un niveau d'échelle et $a_0$ un paramètre d'échelle, et a ensembles de valeurs caractéristiques sont obtenues par la décomposition successive, pour chaque valeur j variant de 0 à un niveau de décomposition donné, de chaque ensemble de coefficients d'ondelettes $w_{j,p}$ en $a_0$ ensembles de coefficients d'ondelettes $W_{j+1,p}$. Ceci permet d'obtenir un niveau détail important lors de la décomposition en ondelettes.

De préférence, le niveau de décomposition donné correspond à un niveau maximal de décomposition, ce qui permet d'atteindre un niveau de détail maximal lors de la décomposition en ondelettes.

Dans un mode de réalisation préféré, l'étape de détermination comporte une étape de comparaison des valeurs caractéristiques par rapport à au moins un élément de détermination séparant au moins une première classe de défaut d'une deuxième classe de défaut. Avantageusement, l'élément de détermination est défini au moyen d'une classification préalable d'une pluralité de valeurs caractéristiques en une pluralité de classes de défauts.

De préférence, entre l'obtention de la pluralité de valeurs caractéristiques et la détermination du défaut, une étape de sélection d'au moins une valeur pertinente ($Val_i'$) parmi la pluralité de valeurs caractéristiques obtenues, la détermination du défaut s'effectuant à partir de ladite valeur pertinente. Ceci permet d'accélérer le temps de calcul.

Le procédé peut comprendre, de façon particulièrement avantageuse, une étape préliminaire de traitement de la grandeur reçue du dispositif électrochimique. En particulier, cette étape préliminaire de traitement comprend une étape d'élimination d'au moins une composante de fréquence de la grandeur reçue du dispositif électrochimique, afin d'optimiser le temps de calcul nécessaire.

L'invention propose en outre un programme informatique comportant des instructions pour mettre en œuvre les étapes du procédé ci-avant.

L'invention propose par ailleurs un dispositif de détection de défauts d'un dispositif électrochimique tel que défini dans la revendication 9.

Le procédé, le programme informatique et le dispositif de détection de défauts, objets de l'invention, seront mieux compris à la lecture de la description et à l'observation des dessins ci-après sur lesquels :

- la figure 1 illustre les étapes d'un procédé de détection de défaut dans un dispositif électrochimique selon l'invention;

- la figure 2 illustre un premier type d'arborescence complète découlant de l'utilisation d'une transformation discrète en ondelettes ;

- la figure 3 illustre un deuxième type d'arborescence partielle découlant de l'utilisation d'une transformation discrète en ondelettes ;

- la figure 4 illustre les notions de marge, de vecteurs support et d'hyperplan séparateur tels que définis dans une méthode de classification préalable ;

- la figure 5 illustre un exemple de classification préalable de défauts selon la présente invention, dans l'exemple particulier d'une pile à combustible ; et

- la figure 6 représente schématiquement un dispositif de détection de défaut dans un dispositif électrochimique selon la présente invention.

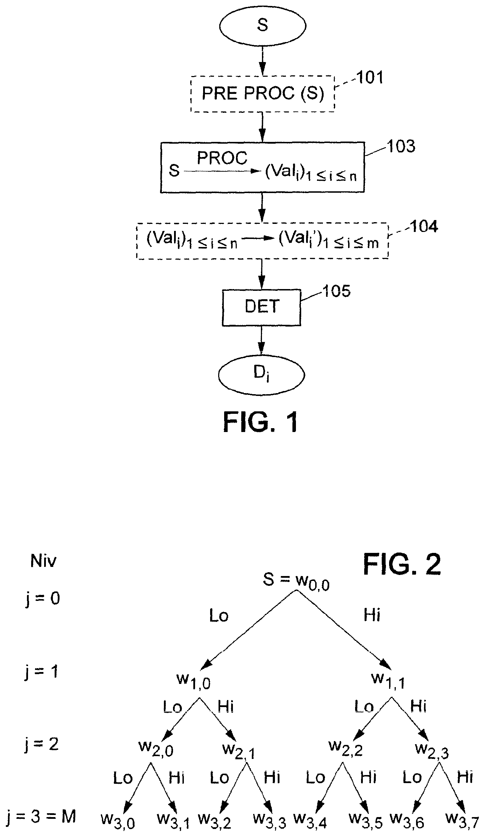

On se réfère tout d'abord à la **figure 1** sur laquelle sont illustrées les étapes d'un procédé de détection de défauts dans un dispositif électrochimique selon la présente invention.

On rappelle tout d'abord que le terme de « dispositif électrochimique » employé ici recouvre aussi bien tout dispositif apte à générer de l'énergie électrique, par conversion d'énergie chimique, de fournir celle-ci (soit directement, soit grâce au stockage temporaire de cette énergie électrique) que tout dispositif apte à utiliser la conversion de l'énergie électrique en énergie chimique, par exemple pour réaliser des réactions chimiques, séparer des produits ou des réactifs entre eux.

Un tel dispositif peut consister en une batterie, une pile à combustible, une supercapacité d'une part. Un tel dispositif peut consister d'autre part en un électrolyseur comme par exemple un réacteur à électrodéposition, à électroérosion, à électrosynthèse, à électropurification, à électroconcentration ou d'électroflottation. Un tel dispositif peut aussi consister en un électrodialyseur.

Afin de détecter un éventuel défaut d'un dispositif électrochimique, le procédé de la présente invention va comprendre un certain nombre d'opérations successives effectuées sur une grandeur S reçue du dispositif électrochimique, ce qui permet d'effectuer un diagnostic non intrusif, ne nécessitant pas l'insertion de capteurs internes dans la source.

La grandeur S reçue de la source peut consister en un signal de n'importe quelle nature permettant de caractériser le dispositif électrochimique.

Dans le cas d'un dispositif générateur d'électricité, cette grandeur S peut être simplement tout signal, tel qu'une tension, une intensité ou une puissance électrique, délivré en sortie du dispositif.

Dans le cas d'un dispositif utilisant de l'électricité pour effectuer une transformation chimique, cette grandeur S peut être la réponse du dispositif à un paramètre imposé en entrée d'un tel dispositif. Si par exemple une intensité est imposée en entrée, la grandeur S peut être la réponse en tension de ce dispositif. A l'inverse, si une tension est imposée en entrée, la grandeur peut être la réponse en intensité de ce dispositif. Enfin, si une puissance est imposée en entrée, la grandeur peut être la réponse en intensité ou en tension du dispositif.

Dans l'exemple non limitatif utilisé par la suite, cette grandeur S est la tension de sortie mesurée aux bornes d'une pile fonctionnant à courant imposé, mais on peut très bien imaginer utiliser le courant d'une pile fonctionnant en tension ou puissance imposée, la puissance d'une pile fonctionnant en tension ou courant imposé ou, quelque soit le mode de fonctionnement, les pressions ou concentrations de produits ou de réactifs, les débits de réactifs ou de produits, la température ou toute variation temporelle ou spatiale de ces grandeurs.

Au cours d'une première étape principale 103, un premier traitement va être appliqué à la grandeur S reçue du dispositif électrochimique à diagnostiquer, afin d'en obtenir une ou plusieurs valeurs $Val_i$, où $1 \leq i \leq n$, permettant de caractériser un ou plusieurs défaut(s) du dispositif électrochimique.

En particulier, si la grandeur S est de nature analogique, les valeurs caractéristiques $Val_i$ obtenues seront des variables numériques permettant un traitement numérique ultérieur.

A partir de ces valeurs caractéristiques $Val_i$ obtenues, on peut alors déterminer un ou plusieurs défaut(s) du dispositif électrochimique lors d'une deuxième étape principale 105.

L'étape 105 peut être soit de nature non supervisée, où il s'agit de répartir les caractéristiques $Val_i$ dans des structures plus ou moins organisées, en les regroupant selon un critère défini ou encore de nature supervisée à partir d'un ensemble de données déjà classées.

Pour ce faire, et dans le cas supervisé par exemple, on compare les valeurs caractéristiques $Val_i$ obtenues avec une série de valeurs classées préalablement et associées chacune à un état particulier du dispositif électrochimique, par exemple un état où un type de défaut particulier est présent. De cette comparaison peut être alors déduit au moins un éventuel défaut $D_i$ du dispositif électrochimique.

Dans la présente invention, le procédé est donc d'abord caractérisé par l'utilisation d'une opération mathématique comprenant une transformation en ondelettes lors de la première étape principale 103, afin d'obtenir les valeurs $Val_i$ à partir de la grandeur S reçue.

Une ondelette est une fonction mathématique $\psi$ localisée autour d'un temps central et limitée dans le temps. Son caractère oscillatoire et compact lui donne son nom (ondelette). Toute fonction mathématique peut être considérée comme une ondelette si elle présente les caractéristiques d'être oscillante, d'énergie finie et de moyenne égale à zéro.

Un premier avantage de l'analyse en ondelettes par rapport aux autres méthodes d'analyse d'une grandeur consiste en ce qu'une multitude de fonctions sont utilisables comme « ondelette mère ».

Une fonction fréquemment utilisée comme « ondelette mère » est la fonction « chapeau mexicain ». Son expression mathématique est la suivante :

$$(1) \qquad \psi(t) = (1 - t^2)e^{-\frac{t^2}{2}}$$

A partir de cette « ondelette mère », on définit une famille d'ondelettes $(\psi_{a,b}(t))_{a,b}$ par translation temporelle et par dilatation (ou compression de l'ondelette) selon la formule suivante :

$$(2) \qquad \psi_{a,b} = \frac{1}{\sqrt{a}}\psi\left(\frac{t-b}{a}\right)$$

C'est cette famille d'ondelettes, servant de base de décomposition, qui permet l'analyse d'une grandeur S donnée. La variable b, dite « variable de translation », est un paramètre de localisation temporelle tandis que la variable a, dite « variable d'échelle », correspond à un facteur d'échelle. Les grandes échelles correspondent à une vue globale du signal, et les petites échelles correspondent à la description des détails. Grâce à la transformée en ondelettes, une grandeur est analysée à toutes les échelles, ce qui permet une analyse multi-résolution.

On peut ainsi faire ressortir l'information sur différents phénomènes (et par conséquent défauts) ayant lieu à différentes échelles contenues dans ce signal. A chaque niveau de décomposition, on obtient un signal à une échelle différente, ce qui permet de localiser les phénomènes en passant d'une échelle de décomposition à la suivante (plus fine).

Pour effectuer une transformée en ondelettes, pour chaque variable d'échelle a, on déplace l'ondelette à partir de l'origine de l'axe des temps tout le long de la grandeur à analyser (en faisant varier la variable de translation b) afin de calculer une suite de corrélations entre les deux.

Les résultats de ces corrélations correspondent à un ensemble de "coefficients en ondelettes", appelés $S_{a,b}$ qui sont d'autant plus grands que la forme de l'ondelette approche celle de la grandeur à analyser, et qui vérifient l'équation suivante :

$$(3) \qquad S_{a,b} = \int_R S(t)\psi *_{a,b}(t)dt$$

où * désigne le conjugué et R l'ensemble des nombres réels. La grandeur S est alors décrite par ces coefficients $S_{a,b}$, lesquels peuvent servir de valeurs caractéristiques $Val_i$ pour déterminer par la suite un défaut du dispositif.

On parle ici de « transformée continue en ondelettes » d'une grandeur S (en anglais Continuous Wavelet Transform ou CWT) lorsque les variables a et b sont variées de façon continue. Une telle "transformée en ondelettes continue" permet une description complète du signal S(t) au détriment de la difficulté à mettre en œuvre l'équation (2) et la grande redondance résultante.

Pour surmonter cette difficulté, il est avantageux d'utiliser un type de transformée en ondelettes dite « discrète », se limitant à l'utilisation de quelques valeurs discrètes pour les variables a et b. Pour de nombreuses applications, on choisit des valeurs de a et b définies par :

$$(4) \qquad a = a_0^j \text{ avec } a_0 > 1$$

$$(5) \qquad b = k.b_0.a_0^j, \text{ avec } b_0 > 0 \text{ et } j \text{ et } k \text{ entiers}$$

Les variables j et k sont les niveaux respectivement d'échelle et de translation. Le résultat obtenu est une série de valeurs discrètes : on parlera donc ici de « décomposition en séries d'ondelettes ». A titre purement illustratif, on choisira ici les valeurs $b_0 = 1$ et $a_0 = 2$, correspondant à une décomposition dite « dyadique » dans laquelle la variable d'échelle a prend les valeurs successives 1,2,4,8,etc...

Dans ce cas particulier, les ondelettes servant à décomposer le signal vérifient l'équation :

$$(6) \qquad \psi_{j,k}(t) = \frac{1}{\sqrt{2^j}}\psi\left(\frac{t - 2^j k}{2^j}\right), \quad (j,k) \in Z^2$$

Et les « coefficients d'ondelettes » sont définis par :

$$(7) \qquad S_{j,k} = \int_R S(t)\psi *_{j,k}(t)dt$$

Et la grandeur S d'origine est définie sur la base d'ondelettes correspondantes selon :

$$(8) \qquad S(t) = \sum_{j \in Z}\sum_{k \in Z} S_{j,k}\psi_{j,k}(t)$$

Du simple point de vue du traitement du signal, il n'existe que deux types d'éléments à considérer : la grandeur à analyser et la fonction qui l'analyse ou la filtre. De ce point de vue, la transformée discrète en ondelettes d'un signal peut être vue comme le passage de ce signal par un « banc de filtres ».

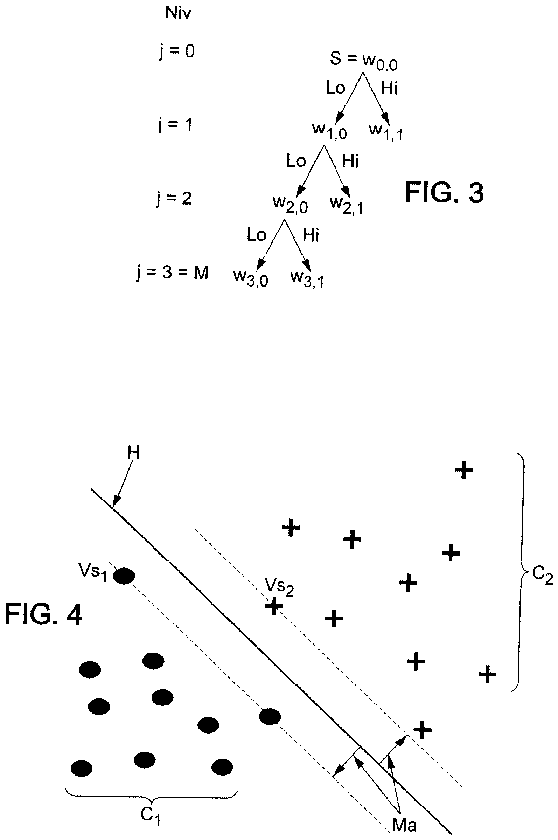

A une échelle donnée, la transformation discrète en ondelettes consiste à faire passer les coefficients d'une échelle précédente par un banc constitué de $a_0$ filtres. Dans un exemple où le facteur $a_0$ est égal à 2, un filtre passe-bas donne une image grossière du signal et un filtre passe-haut donne les détails. Ces deux filtres sont complémentaires : les fréquences coupées par l'un sont récupérées par l'autre. L'emploi itératif de bancs de filtres résulte en des arborescences illustrées par les figures 2 et 3.

A chaque niveau d'échelle j, on obtient des ensembles $w_{j,p}$ des coefficients où le paramètre p indique la position dans l'arbre et varie entre 0 et $2^j - 1$, et est égal, pour chaque nœud correspondant à un ensemble de coefficients $w_{j,p}$, au nombre de « nœuds » situés à sa gauche. Il peut être considéré comme un indice fréquentiel. L'ensemble $W_{j,p}$ comprend une suite de coefficients $S_{j,k}$, où k varie de 0 à $2^{M-j}-1$, ce paramètre M correspondant à un niveau maximal de décomposition du signal à décomposer, lequel peut correspondre, par exemple dans le cas où la longueur de ce signal est une puissance entière de 2, au logarithme népérien de la longueur de ce signal.

Pour un niveau d'échelle j fixé, l'ensemble $w_{j,p}$ de coefficients vérifie donc :

$$(9) \qquad w_{j,p} = \left\{ S_{j,k}, \ k = 0,...,2^{M-j}-1 \right\}$$

Sur la **figure 2** est illustrée une grandeur S à laquelle sont appliqués trois niveaux successifs de filtrage. Ainsi, à chaque niveau d'échelle j allant de 0 à un niveau maximal de décomposition M, on obtient une succession d'ensembles de coefficients $w_{j,p}$ correspondant à l'application des filtres passe-bas (symbolisée par « Lo ») et passe-haut (symbolisée par « Hi ») sur chacun des ensembles de coefficients $w_{j-1,p}$ du niveau d'échelle précédent j-1.

Une telle transformation, intitulée « transformation par paquets d'ondelettes », est complète dans le sens où elle permet de caractériser entièrement la grandeur S, à chaque niveau de décomposition complète. Au niveau j, on obtient $2^j$ ensembles de coefficients (ou nœuds). Puisque le signal est représenté entièrement à chaque niveau de décomposition, cette représentation de la grandeur S au moyen d'un « arbre » complet à plusieurs niveaux est redondante. Avec une telle arborescence, il est possible de sélectionner seulement les paquets « significatifs » d'un défaut donné et n'utiliser que ces paquets pour identifier ce défaut.

La **figure 3** illustre un autre exemple d'arborescence partielle à trois niveaux successifs de filtrage. Dans ce cas précis, on applique les filtrages passe-haut et passe-bas seulement à l'ensemble des coefficients $W_{j,p}$ présentant une variable de « position dans l'arbre » p nulle (représentant les composantes « basses fréquences » de la grandeur S), ici respectivement sur les ensembles $w_{0,0}$, $w_{1,0}$ et $w_{2,0}$, correspondant respectivement à des échelles de valeur a=0, a=2 et a=4.

Dans ce cas de figure, on limite la décomposition aux seuls ensembles de coefficients $w_{j,0}$ pour tout j. Les composantes « hautes fréquences » de la grandeur S ne sont plus décomposées et sont donc analysés avec un niveau de détail moindre que celui des basses fréquences.

Une telle décomposition, où l'on sélectionne les coefficients à obtenir, est moins complète que la décomposition de la figure 2 mais peut être utile lorsque l'on sait d'avance dans quelle gamme décomposer la grandeur S pour déterminer un défaut. Dans ce cas, cette décomposition est plus rapide, plus efficace en temps de calcul et se focalise directement sur un type de défaut particulier.

De manière plus générale, les coefficients obtenus après la décomposition en ondelettes ou en paquets d'ondelettes permettent d'exploiter le contenu fréquentiel de ces signaux. Tout changement dans la grandeur décomposée et lié à un défaut donné se verra sur un ou plusieurs niveaux de décomposition dans le cas d'une transformée discrète en ondelettes ou sur un ou plusieurs paquets dans le cas d'une décomposition en paquets d'ondelettes.

Une telle décomposition va permettre de caractériser, grâce aux différents ensembles de coefficients $W_{j,p}$ obtenus, plusieurs caractéristiques de l'énergie et l'entropie, et par exemple la moyenne, le maximum, le minimum, l'écart-type, le nombre d'événements conformes à un critère, etc. Ces caractéristiques (tout comme les ensembles de coefficients $w_{j,p}$) correspondent aux valeurs caractéristiques $Val_i$ qui serviront à la détermination d'un éventuel défaut lors de la deuxième étape principale 105.

Pour ce faire, on compare les valeurs $Val_i$ obtenues avec une série de valeurs classées préalablement et associées chacune à un état particulier du dispositif électrochimique, par exemple un état normal $D_0$ ou à un état $D_i$ correspondant à un type de défaut particulier. De cette comparaison peut être alors déduit un éventuel défaut du dispositif électrochimique.

Les valeurs utilisées pour la classification préalable sont des valeurs de nature similaire aux valeurs caractéristiques obtenues lors de l'étape 103, lesquelles sont classées dans une ou plusieurs classes de défauts $C_1$, $C_2$ correspondant chacune à un type de défaut en particulier. Cette association d'une valeur à un défaut peut être réalisée grâce à des données du constructeur du dispositif à analyser ou par apprentissage et retour d'expérience.

La classification préalable de valeurs en classes de défauts va permettre de définir un ou plusieurs éléments de détermination séparant ces classes. La comparaison des valeurs caractéristiques obtenues $Val_i$ avec ces éléments de détermination, lors de l'étape 105, permet alors de déterminer si la valeur $Val_i$ appartient à une classe de défaut.

De tels éléments de détermination prennent une forme dépendant du nombre de dimensions considéré. Si la classification préalable se fait par rapport à un seul axe de détermination, ces éléments de détermination seront des valeurs seuils auxquelles seront comparées les valeurs $Val_i$.

Dans une classification en deux dimensions, c'est-à-dire où l'on observe la corrélation entre deux valeurs $Val_i$, les éléments de détermination seront par exemple des droites. D'une façon générale, l'élément de détermination sera une surface séparatrice dans un espace de dimension N, par exemple : un hyperplan séparateur dans le cas linéaire.

La classification préalable des valeurs peut être effectuée selon diverses méthodes. Une méthode particulièrement avantageuse consiste en l'utilisation de machines à vecteurs de support.

Les machines à vecteurs de support (Support Vector Machine, ou SVM, en anglais) sont des techniques de discrimination basées sur l'apprentissage supervisé.

Ces machines à vecteurs support présentent l'avantage de pouvoir travailler avec des données de grande dimension, d'être bien fondés théoriquement, et de présenter de bons résultats en pratique. De plus, quel que soit le modèle d'application, la performance des machines à vecteurs supports est de même ordre, voire supérieure à celle des autres méthodes de classification.

Les machines à vecteurs de support sont basées sur les deux idées essentielles suivantes :

1) La construction d'une frontière « optimale » de séparation entre les classes, permettant de maximiser la distance minimale de la frontière à l'ensemble de l'apprentissage. Ceci est fait en formulant le problème comme un problème d'optimisation quadratique, pour lequel des algorithmes connus sont mis en œuvre.
2) Les machines à vecteurs de support transforment l'espace de représentation des données d'entrée en un espace de plus grande dimension, possiblement de dimension infinie, afin de pouvoir ramener des cas où les données ne sont pas linéairement séparables à un cas plus simple de séparation linéaire dans un espace approprié, grâce à l'utilisation de fonctions dites noyau (ou kernel).

Cette méthode permet initialement de classifier les variables dans deux classes. Néanmoins, il existe des extensions pour la classification dans un nombre plus importants de classes.

Considérons le cas de deux classes « -1 » et « +1 » à séparer et l'ensemble d'apprentissage suivant :

$$(10) \qquad D = \left\{ (x_i, y_i) \in R^N \times \{-1,1\} \text{ pour } i = 1,...k \right\}$$

Deux cas se présentent pour la construction de l'hyperplan optimal séparant les données appartenant aux deux différentes classes : soit les données sont linéairement séparables, soit les données ne sont pas linéairement séparables.

Dans le premier cas où les données sont linéairement séparables, l'hyperplan optimal H satisfait à :

$$(11) \qquad \begin{cases} h(x_i) = w.x_i + b \geq 1, & \text{si } y_i = +1 \\ h(x_i) = w.x_i + b \leq -1, & \text{si } y_i = -1 \end{cases}$$

Ce qui peut s'écrire aussi sous la forme:

$$(12) \qquad y_i.h(x_i) = y_i(w.x_i + b) \geq 1, \quad \text{pour } i = 1,...k$$

La distance d'un point x à l'hyperplan est alors donnée par la projection orthogonale de ce point sur l'hyperplan, selon l'équation suivante :

$$(13) \qquad d(x) = \frac{|w.x + b|}{\|w\|}$$

On peut alors définir une marge Ma correspondant à la plus petite distance entre les observations des deux classes et l'hyperplan :

$$(14) \qquad Ma = \min_{x,y=1} \frac{|w.x + b|}{\|w\|} - \max_{x,y=-1} \frac{|w.x + b|}{\|w\|} = \frac{2}{\|w\|}$$

L'hyperplan Séparateur optimal H, c'est-à-dire la frontière de décision, est celui qui maximise cette marge Ma, ce qui revient à maximiser la somme des distances des deux classes par rapport à l'hyperplan, et donc à minimiser $\|w\|$ sous la contrainte de l'équation (7). Il peut être cependant plus aisé de minimiser $\|w\|^2$ que $\|w\|$.

Ainsi, le problème de minimisation peut être formulé comme un problème de minimisation d'une fonction quadratique avec contraintes linéaires suivantes :

$$(15) \qquad \begin{cases} \min \dfrac{1}{2}\|w\|^2 \\ y_i(w.x_i + b) \geq 1, \quad \forall i \in \{1,...k\} \end{cases}$$

La **figure 4** permet de visualiser ces notions de marge, de vecteurs support et d'hyperplan séparateur H dans un cas particulier à deux dimensions.

Sur cette figure, deux groupes de valeurs sont classés dans deux classes $C_1$ et $C_2$ représentant respectivement un défaut $D_1$ et $D_2$. L'hyperplan séparateur H, représentant la frontière entre ces deux classes $C_1$ et $C_2$ est celui qui minimise la marge Ma définie par rapport aux valeurs limites $Vs_1$ et $Vs_2$ respectives de chaque classe $C_i$ appelées « Vecteurs support ».

Une fois cet hyperplan séparateur H défini par apprentissage préalable, l'étape de détermination 105 consiste à situer les valeurs caractéristiques obtenues par rapport à cet hyperplan séparateur H, ce qui permet de classer ces valeurs dans une des classes $C_1$ et $C_2$ et d'en déduire le défaut $D_i$ associé.

La résolution du problème de minimisation énoncé dans (15) se fait en utilisant les multiplicateurs de Lagrange, par exemple, pour chaque contrainte. On obtient dans ce cas l'équation suivante :

$$(16) \qquad L(w,b,\alpha) = \frac{1}{2}\|w\|^2 - \sum_{p=1}^{k} \alpha_p.(y_p(w.x_p + b) - 1)$$

Le lagrangien doit être minimisé par rapport à w et b, et maximisé par rapport à $\alpha$.

En annulant les dérivées partielles du lagrangien, selon les conditions de Kuhn-Tucker, on obtient le système suivant :

$$(17) \qquad \begin{cases} \max \sum_i \alpha_i - \dfrac{1}{2}\sum_{i,j} \alpha_i \alpha_j y_i y_j x_i.x_j \\ \alpha_i \geq 0 \text{ pour tout } i \\ \sum_i \alpha_i y_i = 0 \end{cases}$$

Les multiplicateurs de Lagrange optimaux sont donc $\alpha_i^*$. On montre que si les $\alpha_i^*$ sont solutions de ce système, on a alors :

$$(18) \qquad w^* = \sum \alpha_i^* y_i x_i$$

Seuls les $\alpha_i^*$ correspondants aux points les plus proches sont non nuls (les vecteurs supports $Vs_1$ et $Vs_2$ sur la figure 4).

L'hyperplan séparateur dans le cas de cas linéaire est donc obtenu en remplaçant w par sa valeur optimale $w^*$. On obtient alors, l'équation suivante :

$$(19) \qquad h(x) = \sum_i \alpha_i^* y_i x_i.x + b$$

Dans l'autre cas où les données ne sont pas linéairement séparables, l'hyperplan optimal est celui qui satisfait les conditions suivantes :

1) la distance maximale entre les vecteurs bien classés et l'hyperplan optimal doit être maximale,

2) la distance entre les vecteurs mal classés et l'hyperplan optimal doit être minimale.

Plus formellement, on applique aux vecteurs d'entrée x une transformation non-linéaire $\varphi$. L'espace d'arrivée est appelé espace de « redescription ». Dans cet espace, on cherche alors l'hyperplan vérifiant :

(20) $$H : x \rightarrow w.\varphi(x) + b$$

avec $y_i h(x_i) > 0$, pour tous les points de l'ensemble d'apprentissage, c'est-à-dire l'hyperplan séparateur dans l'espace de redescription.

En utilisant la même procédure que dans le cas de séparation linéaire précédent, le problème d'optimisation peut alors s'écrire de la façon suivante :

(21)
$$\begin{cases} \max \sum_i \alpha_i - \frac{1}{2} \sum_{i,j} \alpha_i \alpha_j y_i y_j \varphi(x_i).\varphi(x_j) \\ \alpha_i \geq 0 \text{ pour tout } i \\ \sum_i \alpha_i y_i = 0 \end{cases}$$

En introduisant une fonction Noyau (kernel) définie par $K(x_i, x_j) = \varphi(x_i).\varphi(x_j)$, l'hyperplan séparateur dans le cas non linéaire a alors pour équation :

(22)
$$g(x) = \sum_i \alpha_i^* y_i K(x_i, x) + b$$

L'utilisation d'une fonction Noyau permet de faire le passage vers le cas linéaire précédemment décrit. Il existe de nombreuses fonctions noyaux, comme par exemple des fonctions linéaires, polynomiales, Gaussienne, Laplacienne, etc.

D'autres méthodes de classification préalable peuvent être utilisées, comme par exemple une méthode utilisant des réseaux de neurones ou une méthode utilisant les k plus proches voisins.

Dans un mode de réalisation avantageux, une première étape optionnelle 101 de traitement préliminaire est réalisée avant la première étape principale 103, afin de prétraiter la grandeur S pour optimiser le procédé de détection de caractéristiques.

Un exemple de prétraitement consiste en la suppression de composantes de fréquences non significatives de la grandeur S, dans le cas où l'étape principale 103 utilise une décomposition en ondelettes, ce qui permet alors d'optimiser cette décomposition, puisque seules les composantes significatives seront décomposées.

Pour ce faire, on peut utiliser un filtre dont la fréquence de coupure à appliquer est un seuillage. La valeur du seuil est, par exemple, déterminée empiriquement à partir d'un retour d'expérience, de la connaissance du système ou de la bande de fréquence significative.

Dans un mode de réalisation particulièrement avantageux, une étape d'optimisation 104 est réalisée entre la première étape principale 103 et la deuxième étape principale 105 de détermination du défaut, afin de sélectionner certaines valeurs $Val_i$ optimales parmi celles qui sont obtenues lors de l'étape 103.

En effet, l'utilisation directe des valeurs $Val_i$ dans l'étape de détermination d'un défaut peut présenter des problèmes lorsque l'ensemble de valeurs caractéristiques $Val_i$ générées lors de l'étape 103 est d'une part très grand, et d'autre part entaché de bruit ou de composantes indésirables.

De plus, les valeurs caractéristiques $Val_i$ contiennent souvent des informations redondantes, et ne nécessitent donc pas toutes d'être traitées.

Aussi, afin d'optimiser le processus de détermination de l'étape 105, il est souhaitable de réduire autant que possible le nombre de valeurs $Val_i$ à traiter, au cours d'une étape de sélection 104, afin de ne garder que les valeurs les plus pertinentes $Val'_i$, où $1 \leq i \leq m$ avec $m < n$, considérées comme étant les meilleures pour l'étape de détermination 105. Ceci contribue à améliorer la robustesse du diagnostic du dispositif électrochimique et à réduire le temps de calcul.

Pour cela, on peut utiliser une méthode de sélection de la meilleure base en ondelettes dans un mode particulier de réalisation. Cette méthode se base sur l'utilisation d'un critère pour sélectionner une base dite « meilleure base ».

Cette méthode comporte les deux étapes suivantes :

- Appliquer un critère choisi aux jeux de valeurs caractéristiques $Val_i$ obtenus lors de la décomposition en ondelettes de l'étape 103.

- Trier les caractéristiques trouvées lors de l'étape précédente par ordre d'importance croissant ou décroissant, selon le critère choisi, afin d'écarter les valeurs caractéristiques $Val_i$ estimées « non significatives ».

Les valeurs caractéristiques $Val_i$ restantes seront alors utilisables lors de l'étape de détermination 105.

Une base optimale pour la détection, par exemple, est une base qui maximise la séparabilité entre les différentes informations fréquentielles et temporelles. Une base optimale pour la détermination est une base qui maximise la séparabilité, autrement dit la discrimination, entre les différentes classes de défauts.

Dans ce cadre, plusieurs critères peuvent être définis.

1) Dans un premier exemple, on utilise l'« entropie relative » (« Cross entropy » en anglais), qui constitue à effectuer une mesure de distance entre les distributions temporelles d'énergie de deux séquences x et y, selon l'équation suivante :

$$(23) \qquad ER(x,y) = \sum_i p_i \log(\frac{p_i}{q_i}) \text{ où } p_i = \frac{|x_i|^2}{\|x\|} \text{ et } q_i = \frac{|y_i|^2}{\|y\|}$$

Cette valeur correspond à la divergence de Kullback entre les distributions xi et yi représentant deux classes différentes.

On peut alors définir un critère D(x,y) à optimiser, tel que :

$$(24) \qquad D(x,y) = ER(x,y) + ER(y,x).$$

Dans cet exemple, on représente tout d'abord chaque classe de l'ensemble d'apprentissage par un arbre où chaque nœud contient une séquence moyenne des carrés des coefficients des éléments de la classe.

Le critère défini ci-avant étant binaire, il est appliqué à toutes les classes deux à deux et le critère final est la somme des critères binaires résultants.

2) Dans un deuxième exemple, dans le but de maximiser la capacité des coefficients ou des paquets obtenus lors de l'étape 103 à séparer les différentes classes lors de l'étape 105, le critère ici consiste à maximiser l'« inertie interclasse », c'est-à-dire la variance entre les classes les plus éloignées l'une de l'autre, tout en minimisant l'« inertie intra classe », c'est-à-dire la variance des classes les plus compactes possibles. Le critère peut donc consister à faire le rapport de l'inertie intra classe sur l'inertie totale. On peut aussi envisager de faire le rapport de l'inertie intra classe sur l'inertie interclasse.

Dans un exemple où l'on dispose de k classes C1, C2,...,Ck de défauts, de centres de gravité respectifs g1, g2,...,gk contenant respectivement n1, n2,...,nk éléments, on peut noter g le centre de gravité du nuage de points global.

L'inertie interclasses est alors définie par l'équation suivante :

$$(25) \qquad I_{inter} = \frac{1}{n} \sum_{i=1}^{k} n_i . d^2(g_i, g)$$

où d est une distance définie, par exemple une distance euclidienne.

L'inertie intra classe est de son côté définie par l'équation suivante :

$$(26) \qquad I_{intra} = \frac{1}{n} \sum_{e \in G_i}^{k} d^2(g_i, e)$$

Quant à l'inertie totale, elle est définie par l'équation suivante :

$$(27) \qquad I_{totale} = I_{intra} + I_{inter}$$

Le critère final R est donc donné, par exemple, par la relation suivante :

$$(28) \qquad R = \frac{I_{\text{int}\,ra}}{I_{\text{int}\,ra} + I_{\text{int}\,er}}$$

Les classes qui vont être séparées sont préalablement définies. On peut donc soit discriminer toutes les classes de défauts simultanément, séparer les classes deux à deux ou encore séparer une classe donnée de toutes les autres.

Dans un autre mode de réalisation particulier, la réduction de dimensionnalité de l'étape 104 utilise une décomposition en Valeurs Singulières.

Pour mémoire, décomposer une matrice M de m lignes et de n colonnes en valeurs singulières revient à l'écrire sous la forme :

$$(29) \qquad M = U \times \Sigma \times V$$

où $\Sigma$ est une matrice diagonale contenant les valeurs singulières $\lambda_{i,i=1,\ldots m}$ de la matrice $M$, classées par exemple par ordre décroissant.

$$(30) \qquad \Sigma = \begin{pmatrix} \lambda_1 & & & & \\ & \lambda_2 & & 0 & \\ & & & \cdot & \\ & 0 & & & \cdot \\ & & & & \lambda_m \end{pmatrix}$$

Les deux autres matrices U et V contiennent les vecteurs singuliers (à droite et à gauche) correspondants aux valeurs singulières $\lambda_{i,i=1,\ldots m}$.

Les valeurs singulières sont interprétées comme reflétant le degré d'inertie ou de « représentativité » et les vecteurs singuliers sont les axes selon lesquels la variation des données de départ (matrice M) est la plus élevée. Lorsque les valeurs singulières sont classées par ordre décroissant, les dernières valeurs sont celles qui contiennent le moins de variation des données. Ainsi, la réduction de dimensionnalité basée sur le passage de m à p valeurs singulières (p<n) suppose négligeable l'information contenue dans les m-p+1 dernières valeurs singulières $\lambda_i$.

D'autres méthodes peuvent être envisagées pour effectuer la réduction de dimensionnalité, comme par exemple une analyse en composantes principales.

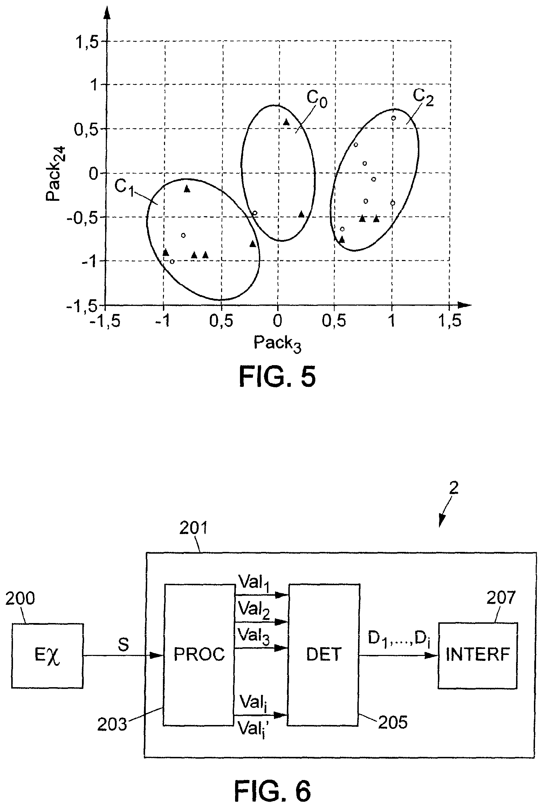

On se réfère enfin à la **figure 5** qui illustre un exemple de classification de défauts selon la présente invention, dans le cas non limitatif d'une pile à combustible.

Sur cette figure 5, un ensemble de valeurs caractéristiques sont représentées sur un graphique en fonction de deux paquets d'ondelettes distincts.

La position de ces valeurs caractéristiques est associée, par apprentissage, à des états de fonctionnement particulier de la pile à combustible à diagnostiquer.

Ainsi, un premier groupe de valeurs caractéristiques, situées au centre sur le graphique, définit une classe $C_0$ de valeurs caractéristiques correspondant à un état normal de fonctionnement de la pile à combustible.

Un deuxième groupe de valeurs caractéristiques, situées à gauche sur le graphique, définit une classe $C_1$ de valeurs caractéristiques correspondant à un état anormal de fonctionnement où la pile à combustible présente un défaut d'assèchement.

Enfin, un troisième groupe de valeurs caractéristiques, situées à droite sur le graphique, définit une classe $C_2$ de valeurs caractéristiques correspondant à un état anormal de fonctionnement où la pile à combustible présente un défaut de « noyage ».

Ces classes $C_0$, $C_1$, $C_2$ sont définies par apprentissage et mesure des valeurs caractéristiques sur des piles présentant les différents états incriminés. Les frontières de ces valeurs classes, par exemple définies par des éléments de détermination calculés comme ci-avant, sont mémorisées dans le module 205 et associées à des variables d'état $D_0$, $D_1$, $D_2$ représentatives respectivement d'un état normal, d'un état anormal avec défaut d'assèchement et d'un état anormal avec défaut de noyage.

Lorsqu'un nouveau diagnostic est effectué sur une pile à combustible de même type que celle utilisée dans la classification supervisée lors de l'apprentissage, les mêmes paquets d'ondelettes sont observés afin de situer la valeur caractéristique dans l'une ou l'autre des zones $Z_0$ à $Z_2$. En fonction de la zone dans laquelle se situe la valeur caractéristique mesurée, une variable d'état $D_0$ à $D_2$ sera générée par le module de détermination 205, indicative d'un état particulier.

On se réfère maintenant à la **figure 6,** sur laquelle est représenté schématiquement un dispositif de détection d'un défaut dans un dispositif électrochimique selon l'invention.

Sur cette figure, un dispositif électrochimique 200, du type de ceux indiqués précédemment, fournit une grandeur S au dispositif de détection 201.

Ce dispositif de détection 201 comporte un module de traitement 203 connecté à un module de détermination 205, lui-même connecté à un module d'interface 207.

Le module de traitement 203 est adapté pour effectuer la première étape principale 103 de transformation, ainsi que les éventuelles étapes optionnelles 101 et 104 de traitement préliminaire et de sélection de valeurs caractéristiques pertinentes Val$_i$' telles que décrites ci-avant.

Un tel module de traitement 203 peut consister en un processeur, un micro-processeur, ou tout autre composant, par exemple sur circuit intégré, capable d'effectuer des calculs sur des valeurs numériques ou de faire fonctionner un programme informatique à cet effet.

Lorsque la grandeur S à analyser est de nature analogique, le module de traitement 203 peut comprendre un convertisseur analogique/numérique afin de transformer la grandeur S en une valeur numérique permettant son traitement.

Le module de traitement 203, une fois qu'il a effectué l'étape principale 103 d'obtention d'une ou plusieurs valeur(s) Val$_i$, fournit celle(s)-ci au module de détermination de défaut 205. Dans le cas particulier où une étape optionnelle de sélection 104 est aussi effectuée par le module de traitement 203, ce sont les valeurs caractéristiques pertinentes Val$_i$' qui sont alors fournies au module de détermination de défaut 205.

Dans l'exemple de la figure 6, les valeurs Val$_i$ sont indiquées comme étant fournies par plusieurs connexions en parallèle, mais une seule connexion pourrait aussi bien être utilisée, auquel cas la transmission de ces valeurs s'effectue en série. Le premier mode de réalisation en parallèle permet un transfert plus rapide des valeurs, tandis que le second mode de réalisation en série permet de simplifier et de réduire le coût de la connectique entre les modules 203 et 205.

Le module de détermination 205 est adapté pour déterminer une ou plusieurs caractéristique(s) $D_i$ du dispositif électrochimique à partir des valeurs Val$_i$ reçues du module de traitement 205. Il peut comprendre à cet effet des moyens de classification dans lesquels sont classées les caractéristiques en fonction de ces valeurs.

De tels moyens de classification peuvent par exemple utiliser une méthode basée sur un réseau de neurones, ayant été entraîné pour classer les différents défauts sur la base de valeurs reçues en entrée, ou sur la logique floue.

Ces moyens de classification peuvent aussi utiliser des méthodes statistiques comme la détermination des k plus proches voisins, des machines à Vecteurs Supports ou l'analyse en Composantes Principales.

Ainsi, en réponse à un certain nombre de valeurs Val$_i$, le module de détermination 205 va fournir en sortie, grâce à ses moyens de classification, une ou plusieurs variables $D_i$ indicatives d'une caractéristique du dispositif électrochimique, par exemple une caractéristique d'état normal (pour $D_0$) ou d'un ou plusieurs défauts.

Ces valeurs $D_i$ sont alors reçues par un module d'interface 207 qui va indiquer, en fonction de la ou des variable(s) $D_i$ reçues, l'état de fonctionnement du dispositif électrochimique à l'utilisateur du dispositif de détection 201 ou à un système de contrôle-commande situé en aval du dispositif de détection.

Ceci peut se faire sous la forme d'un affichage (ce qui permet de préciser le type d'état ou de défaut en fonction de la variable $D_i$), d'une alarme sonore ou de tout autre signal adapté pour informer l'utilisateur ou le système de régulation et de contrôle-commande situé en aval d'un état de fonctionnement normal ou anormal du dispositif électrochimique à diagnostiquer.

Bien entendu, l'invention n'est pas limitée aux exemples de réalisation cidessus décrits et représentés, à partir desquels on pourra prévoir d'autres modes et d'autres formes de réalisation, sans pour autant sortir du cadre de l'invention telle que revendiquée.

## Revendications

1. Procédé de détection de défaut d'un dispositif électrochimique comprenant une étape préliminaire de traitement (101) d'au moins une grandeur (S) reçue dudit dispositif électrochimique, l'obtention (103) d'une pluralité de valeurs caractéristiques (Val$_i$) de l'énergie et de l'entropie à partir de la grandeur (S) traitée et la détermination (105) d'au moins un défaut ($D_i$) dudit dispositif électrochimique à partir de ladite pluralité de valeurs caractéristiques obtenues, et une opération mathématique comprenant une transformation en ondelettes réalisée pour obtenir ladite pluralité de valeurs caractéristiques (Val$_i$) à partir de la grandeur (S) traitée,

ladite transformation en ondelettes étant une transformation discrète en ondelettes dans laquelle chacune de ladite pluralité de valeurs caractéristiques est obtenue à partir d'au moins un coefficient d'ondelettes ($S_{a,b}$) dépendant d'une variable d'échelle de valeur a et d'une variable de translation de valeur b, et ladite pluralité de valeurs caractéristiques étant obtenue par la décomposition d'un ensemble ($w_{j,p}$) dedits coefficients d'ondelettes ($S_{a,b}$), présentant une variable de niveau d'échelle j de valeur inférieure à a, en une pluralité d'ensembles ($w_{j+1,p}$) dedits coefficients d'ondelettes ($S_{a,b}$).

2. Procédé de détection de défaut selon la revendication 1, dans lequel la variable d'échelle de valeur a vérifie $a=a_0^j$, où j est un niveau d'échelle et $a_0$ un paramètre d'échelle, **caractérisé en ce que** a ensemble de valeurs caractéristiques sont obtenues par la décomposition successive, pour chaque valeur j variant de 0 à un niveau de décomposition donné, de chaque ensemble ($w_{j,p}$) de coefficients d'ondelettes ($S_{a,b}$) en $a_0$ ensembles ($w_{j+1,p}$) de coefficients d'ondelettes ($S_{a,b}$).

3. Procédé de détection de défaut selon la revendication 2, **caractérisé en ce que** le niveau de décomposition donné correspond à un niveau M de décomposition maximale.

4. Procédé de détection de défaut selon l'une des revendications 1 à 3, **caractérisé en ce que** l'étape de détermination comporte une étape de comparaison de ladite pluralité de valeurs caractéristiques par rapport à au moins un élément de détermination (H) séparant au moins une première classe de défaut ($C_1$) d'une deuxième classe de défaut ($C_2$).

5. Procédé de détection de défaut selon la revendication 4, **caractérisé en ce que** l'élément de détermination (H) est défini au moyen d'une classification préalable d'une pluralité de valeurs caractéristiques en une pluralité de classes de défauts ($C_1,C_2$).

6. Procédé de détection de défaut selon l'une des revendications 1 à 5, le procédé étant **caractérisé en ce qu'**il comprend, entre l'obtention (103) de ladite pluralité de valeurs caractéristiques et la détermination (105) du défaut ($D_i$), une étape de sélection (104) d'au moins une valeur pertinente ($Val_i'$) parmi la pluralité de valeurs caractéristiques obtenues, la détermination du défaut ($D_i$) s'effectuant à partir de ladite valeur pertinente ($Val_i'$).

7. Procédé de détection de défaut selon la revendication 6, **caractérisé en ce que** l'étape préliminaire de traitement (101) comprend une étape d'élimination d'au moins une composante de fréquence de la grandeur (S) reçue du dispositif électrochimique.

8. Programme informatique, téléchargeable via un réseau de télécommunication et/ou stocké dans une mémoire d'une unité centrale et/ou stocké sur un support mémoire destiné à coopérer avec un lecteur de ladite unité centrale, **caractérisé en ce qu'**il comporte des instructions pour mettre en œuvre les étapes d'un procédé de détection de défauts selon l'une des revendications 1 à 7.

9. Dispositif de détection de défaut d'un dispositif électrochimique comportant :

   - un module de traitement (203) adapté pour recevoir au moins une grandeur (S) dudit dispositif électrochimique, pour traiter ladite grandeur (S) et pour générer une pluralité de valeurs caractéristiques ($Val_i$) de l'énergie et de l'entropie à partir de ladite grandeur (S) traitée en effectuant une opération mathématique comprenant une transformation en ondelettes, et
   - un module de détermination (205) adapté pour déterminer au moins un défaut dudit dispositif électrochimique à partir de ladite pluralité de valeurs caractéristiques ($Val_i$) reçues du module de traitement, ladite transformation en ondelettes étant une transformation discrète en ondelettes dans laquelle chacune de ladite pluralité de valeurs caractéristiques obtenues comporte au moins un coefficient d'ondelettes ($S_{a,b}$) dépendant d'une variable d'échelle de valeur a et d'une variable de translation de valeur b, et ladite pluralité de valeurs caractéristiques étant obtenue par la décomposition d'un ensemble ($w_{j,p}$) dedits coefficients d'ondelettes ($S_{a,b}$), présentant une variable de niveau d'échelle j de valeur inférieure à a, en une pluralité d'ensembles ($w_{j+1,p}$) dedits coefficients d'ondelettes ($S_{a,b}$).

10. Dispositif de détection de défaut selon la revendication 9, **caractérisé en ce que** le module de détermination comprend des moyens de classification de défauts adaptés pour fournir une variable indicative ($D_i$) d'un défaut en réponse à la pluralité de valeurs caractéristiques reçues du module de traitement.

11. Dispositif de détection de défaut selon la revendication 10, **caractérisé en ce que** les moyens de classification de défauts comportent un réseau de neurones.

**Patentansprüche**

1.  Verfahren zur Fehlererkennung in einer elektrochemischen Vorrichtung, das einen vorbereitenden Schritt der Verarbeitung (101) wenigstens einer von der elektrochemischen Vorrichtung erhaltenen Größe (S), den Erhalt (103) einer Mehrzahl von charakteristischen Werten ($Val_i$) zur Energie und der Entropie aus der verarbeiteten Größe (S) und die Bestimmung (105) wenigstens eines Fehlers ($D_i$) der elektrochemischen Vorrichtung aus der Mehrzahl von erhaltenen charakteristischen Werten, und eine mathematische Operation, die eine Wavelet-Transformation umfasst, die ausgeführt wird, um die Mehrzahl von charakteristischen Werten ($Val_i$) aus der verarbeiteten Größe (S) zu erhalten,

    wobei die Wavelet-Transformation eine diskrete Wavelet-Transformation ist, wobei jeder der Mehrzahl von charakteristischen Werten aus wenigstens einem Wavelet-Koeffizienten ($S_{a,b}$) in Abhängigkeit von einer Skalenvariablen mit dem Wert a und einer Translationsvariablen mit dem Wert b erhalten wird, und die Mehrzahl von charakteristischen Werten durch Zerlegen eines Satzes ($w_{j,p}$) der Wavelet-Koeffizienten ($S_{a,b}$), die eine Skalenniveau-Variable j mit einem Wert kleiner a aufweisen, in eine Mehrzahl von Sätzen ($w_{j+1,p}$) der Wavelet-Koeffizienten ($S_{a,b}$) erhalten wird.

2.  Verfahren zur Fehlererkennung nach Anspruch 1, wobei die Skalenvariable mit dem Wert a $a=a_0^j$ verifiziert, wobei j ein Skalenniveau und $a_0$ ein Skalenparameter ist, **dadurch gekennzeichnet, dass** a Sätze von charakteristischen Werten durch sukzessive Zerlegung erhalten werden, für jeden Wert j, der von 0 bis zu einem gegebenen Zerlegungsgrad variiert, von jedem Satz ($w_{j,p}$) von Wavelet-Koeffizienten ($S_{a,b}$) in $a_0$ Sätze ($w_{j+1,p}$) von Wavelet-Koeffizienten ($S_{a,b}$).

3.  Verfahren zur Fehlererkennung nach Anspruch 2, **dadurch gekennzeichnet, dass** der gegebene Zerlegungsgrad einem maximalen Zerlegungsgrad M entspricht.

4.  Verfahren zur Fehlererkennung nach einem der Ansprüche 1 bis 3, **dadurch gekennzeichnet, dass** der Bestimmungsschritt einen Schritt des Vergleichens der Mehrzahl von Merkmalswerten in Bezug auf wenigstens ein Bestimmungselement (H) umfasst, das wenigstens eine erste Fehlerklasse ($C_1$) von einer zweiten Fehlerklasse ($C_2$) trennt.

5.  Verfahren zur Fehlererkennung nach Anspruch 4, **dadurch gekennzeichnet, dass** das Bestimmungselement (H) durch eine vorherige Klassifizierung einer Mehrzahl von charakteristischen Werten in eine Mehrzahl von Fehlerklassen ($C_1$, $C_2$) definiert wird.

6.  Verfahren zur Fehlererkennung nach einem der Ansprüche 1 bis 5, wobei das Verfahren **dadurch gekennzeichnet ist, dass** es zwischen dem Erhalt (103) der Mehrzahl von charakteristischen Werten und der Bestimmung (105) des Fehlers ($D_i$) einen Schritt des Auswählens (104) wenigstens eines relevanten Wertes ($Val_i$') aus der Mehrzahl von erhaltenen charakteristischen Werten umfasst, wobei die Bestimmung des Fehlers ($D_i$) ausgehend von dem relevanten Wert ($Val_i$') durchgeführt wird.

7.  Verfahren zur Fehlererkennung nach Anspruch 6, **dadurch gekennzeichnet, dass** der Vorverarbeitungsschritt (101) einen Schritt zum Eliminieren wenigstens einer Frequenzkomponente der von der elektrochemischen Vorrichtung erhaltenen Größe (S) umfasst.

8.  Computerprogramm, das über ein Telekommunikationsnetz heruntergeladen werden kann und/oder in einem Speicher einer Zentraleinheit gespeichert ist und/oder auf einem Speichermedium gespeichert ist, das dazu bestimmt ist, mit einem Lesegerät der genannten Zentraleinheit zusammenzuarbeiten, **dadurch gekennzeichnet, dass** es Anweisungen zur Durchführung der Schritte eines Verfahrens zur Fehlererkennung nach einem der Ansprüche 1 bis 7 umfasst.

9.  Vorrichtung zur Fehlererkennung in einer elektrochemischen Vorrichtung, umfassend:

    - ein Verarbeitungsmodul (203), das dazu ausgebildet ist, wenigstens eine Größe (S) von der elektrochemischen Vorrichtung zu empfangen, die Größe (S) zu verarbeiten und eine Mehrzahl von charakteristischen Werten

(Val$_i$) zur Energie und Entropie aus der verarbeiteten Größe (S) zu erzeugen, indem es eine mathematische Operation durchführt, die eine Wavelet-Transformation umfasst, und

- ein Bestimmungsmodul (205), das dazu ausgebildet ist, wenigstens einen Fehler der elektrochemischen Vorrichtung aus der Mehrzahl der vom Verarbeitungsmodul empfangenen charakteristischen Werte (Val$_i$) zu bestimmen,

wobei die Wavelet-Transformation eine diskrete Wavelet-Transformation ist, wobei jeder der Mehrzahl von erhaltenen charakteristischen Werten wenigstens einen Wavelet-Koeffizienten (S$_{a,b}$) umfasst, der von einer Skalenvariablen mit dem Wert a und einer Translationsvariablen mit dem Wert b abhängt,

und wobei die Mehrzahl von charakteristischen Werten durch Zerlegen eines Satzes (w$_{j,p}$) der Wavelet-Koeffizienten (S$_{a,b}$), die eine Skalenniveau-Variable j mit dem Wert kleiner a aufweisen, in eine Mehrzahl von Sätzen (w$_{j+1,p}$) der Wavelet-Koeffizienten (S$_{a,b}$), erhalten wird.

**10.** Vorrichtung zur Fehlererkennung nach Anspruch 9, **dadurch gekennzeichnet, dass** das Bestimmungsmodul Fehlerklassifizierungsmittel umfasst, die dazu ausgebildet sind, als Reaktion auf die Mehrzahl der vom Verarbeitungsmodul empfangenen charakteristischen Werte eine Variable (D$_i$) zu liefern, die einen Fehler anzeigt.

**11.** Vorrichtung zur Fehlererkennung nach Anspruch 10, **dadurch gekennzeichnet, dass** die Fehlerklassifizierungsmittel ein neuronales Netz umfassen.

**Claims**

**1.** Method for detecting a defect in an electrochemical device, comprising a preliminary processing step (101) for at least one variable (S) received from said electrochemical device, the obtaining (103) of a plurality of characteristic values (Val$_i$) of energy and entropy from the processed variable (S) and the determination (105) of at least one defect (D$_i$) of said electrochemical device from said plurality of obtained characteristic values, and a mathematical operation comprising a wavelet transform performed to obtain said plurality of characteristic values (Val$_i$) from the processed variable (S),

wherein said wavelet transform is a discrete wavelet transform in which each of the plurality of characteristic values is obtained from at least one wavelet coefficient (S$_{a,b}$) depending on a scale variable of value a and a translation variable of value b,

and wherein said plurality of characteristic values is obtained by the decomposition of a set (w$_{j,p}$) of said wavelet coefficients (S$_{a,b}$), for which a scalelevel variable j is less than a, into a plurality of sets (w$_{j+1,p}$) of said wavelet coefficients (S$_{a,b}$).

**2.** Method for detecting a defect according to claim 1, wherein the scale variable of value a satisfies $a=a_0^j$, where j is a scale level and $a_0$ is a scale parameter, **characterized in that** a sets of characteristic values are obtained by the successive decomposition, for each value j varying from 0 to a given decomposition level, of each set (w$_{j,p}$) of wavelet coefficients (S$_{a,b}$) into $a_0$ sets (w$_{j+1,p}$) of wavelet coefficients (S$_{a,b}$).

**3.** Method for detecting a defect according to claim 2, **characterized in that** the given decomposition level corresponds to a maximum decomposition level M.

**4.** Method for detecting a defect according to any one of claims 1 to 3, **characterized in that** the determination step comprises a step of comparing said plurality of characteristic values to at least one determination element (H) separating at least one first defect class (C$_1$) from a second defect class (C$_2$).

**5.** Method for detecting a defect according to claim 4, **characterized in that** the determination element (H) is defined by means of a prior classification of a plurality of characteristic values into a plurality of defect classes (C$_1$,C$_2$).

**6.** Method for detecting a defect according to any one of claims 1 to 5, the method being **characterized in that** it comprises, between the obtaining (103) of said plurality of characteristic values and the determining (105) of the defect (D$_i$), a step (104) of selecting at least one relevant value (Val$_i$') from among the plurality of obtained characteristic values, wherein the defect (D$_i$) determination is made from said relevant value (Val$_i$').

**7.** Method for detecting a defect according to claim 6, **characterized in that** the preliminary processing step (101) comprises a step of eliminating at least one frequency component of the variable (S) received from the electrochemical device.

8. Computer program, downloadable via a telecommunication network and/or stored in the memory of a computer and/or stored on a storage medium intended to cooperate with a reader of said computer, **characterized in that** it comprises instructions for implementing the steps of a method for detecting a defect according to any one of claims 1 to 7.

9. Defect detection device for an electrochemical device, comprising:

- a processing module (203) adapted to receive at least one variable (S) from said electrochemical device, for processing said variable (S), and to generate a plurality of characteristic values ($Val_i$) of energy and entropy from said processed variable (S) by performing a mathematical operation comprising a wavelet transform, and
- a determination module (205) adapted to determine at least one defect of said electrochemical device from said plurality of characteristic values ($Val_i$) received from the processing module,
wherein said wavelet transform is a discrete wavelet transform in which each of said plurality of obtained characteristic values comprises at least one wavelet coefficient ($S_{a,b}$) depending on a scale variable of value a and a translation variable of value b,
and wherein said plurality of characteristic values is obtained by the decomposition of a set ($w_{j,p}$) of wavelet coefficients ($S_{a,b}$), for which the scalelevel variable j is less than a, into a plurality of sets ($w_{j+1,p}$) of wavelet coefficients ($S_{a,b}$).

10. Defect detection device according to claim 9, **characterized in that** the determination module comprises a defect classification means adapted to provide a variable ($D_i$) indicative of a defect in response to the plurality of characteristic values received from the processing module.

11. Defect detection device according to claim 10, **characterized in that** the defect classification means comprises a neural network.

**FIG. 1**

**FIG. 2**

Niv

j = 0

$S = w_{0,0}$

Lo / Hi

j = 1

$w_{1,0}$    $w_{1,1}$

Lo / Hi

j = 2

$w_{2,0}$    $w_{2,1}$

FIG. 3

Lo / Hi

j = 3 = M

$w_{3,0}$    $w_{3,1}$

FIG. 4

H

$Vs_1$

$Vs_2$

$C_2$

$C_1$

Ma

FIG. 5

FIG. 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- A carbon monoxide sensor in polymer electrolyte fuel cells based on symbolic dynamic filtering. **BHAMBARE K S et al.** SENSORS AND ACTUATORS B: CHEMICAL. ELSEVIER BV, 25 Septembre 2008, vol. 134, 803-815